Europäisches Patentamt

European Patent Office

Office européen des brevets

(19)

(11) **EP 0 936 743 A1**

(12) **DEMANDE DE BREVET EUROPEEN**

(43) Date de publication:
**18.08.1999 Bulletin 1999/33**

(51) Int Cl.⁶: **H03M 13/00**

(21) Numéro de dépôt: **99200361.6**

(22) Date de dépôt: **08.02.1999**

(84) Etats contractants désignés:
**AT BE CH CY DE DK ES FI FR GB GR IE IT LI LU MC NL PT SE**
Etats d'extension désignés:
**AL LT LV MK RO SI**

(30) Priorité: **17.02.1998 FR 9801905**

(71) Demandeur: **Koninklijke Philips Electronics N.V.**
**5621 BA Eindhoven (NL)**

(72) Inventeur: **Chouly, Antoine**
**75008 Paris (FR)**

(74) Mandataire: **Landousy, Christian**
**Société Civile S.P.I.D.**
**156, Boulevard Haussmann**
**75008 Paris (FR)**

(54) **Décodage itératif pour codes binaires en bloc**

(57)    L'invention utilise une méthode de décodage itératif pour décoder un code binaire en bloc défini par une matrice de contrôle de parité.

La matrice de parité est traitée ligne par ligne plusieurs fois de telle sorte que chaque itération du décodage itératif correspond au décodage du code défini par une ligne de la matrice pour des données reçues.

Lorsque le code est un code étendu, chaque ligne définit deux codes distincts qui sont décodés en parallèle à chaque itération.

Application : tranqmission numérique notamment.

FIG.5

EP 0 936 743 A1

**Description**

L'invention concerne un système de transmission numérique comportant en émission des moyens de codage de données d'entrée à partir d'un code binaire en bloc défini par une matrice de contrôle de parité, et en réception des moyens de décodage pour prendre des décisions sur des données reçues.

L'invention concerne également un procédé de décodage de données préalablement codées à partir d'un code binaire en bloc défini par une matrice de contrôle de parité et un décodeur de données préalablement codées à partir d'un code binaire en bloc défini par une matrice de contrôle de parité.

L'invention a d'importantes applications, notamment dans le domaine de la transmission numérique de données.

L'article "A Class of Algorithms for Decoding Block Codes With Channel Measurement Information" écrit par David Chase et publié dans la revue IEEE Transactions on Information Theory, vol. IT-18, n° 1, janvier 1972, décrit une méthode de décodage des codes binaires en bloc.

L'invention a pour but de proposer une méthode beaucoup plus simple, qui permet d'obtenir des performances du même ordre.

Pour cela, un système de transmission numérique selon l'invention et tel que décrit dans le paragraphe introductif est caractérisé en ce que lesdits moyens de décodage sont des moyens de décodage itératif, chaque itération correspondant au décodage, pour des données reçues, du ou des codes définis par une ligne de la matrice.

De même, un procédé de décodage selon l'invention et tel que décrit dans le paragraphe introductif est caractérisé en ce que ledit procédé est un procédé de décodage itératif qui comporte à chaque itération une étape de décodage, pour des données reçues, du ou des codes définis par une ligne de la matrice.

Et un décodeur selon l'invention et tel que décrit dans le paragraphe introductif est caractérisé en ce qu'il comporte des moyens de décodage itératif, chaque itération correspondant au décodage, pour des données reçues, du ou des codes définis par une ligne de la matrice.

Lorsque ledit code binaire en bloc est un code étendu, chaque ligne de la matrice définit deux codes distincts, et de façon avantageuse lesdits moyens de décodage itératif comportent des moyens de traitement en parallèle de chacun des deux codes.

Enfin, dans un mode de réalisation avantageux de l'invention, lesdits moyens de décodage comportent, pour le traitement de certaines itérations au moins:

- des moyens de calcul, à partir de grandeurs d'entrée, d'informations de fiabilité relatives à des décisions douces,

- des moyens de transformation pour calculer des informations transformées à partir desdites décisions douces de façon à normaliser la valeur moyenne desdites informations de fiabilité,
- des moyens de pondération pour calculer des sommes pondérées desdites informations transformées et des données reçues avec un premier et un second coefficient de pondération respectivement,
- des moyens d'élaboration de grandeurs d'entrée à réinjecter pour l'itération suivante à partir desdites sommes pondérées.

L'invention sera mieux comprise et d'autres détails apparaîtront dans la description qui va suivre en regard des dessins annexés qui sont donnés à titre d'exemple non limitatif et dans lesquels :

- la figure 1 représente schématiquement un système de transmission selon l'invention,
- la figure 2 représente les différentes étapes d'un procédé de décodage selon l'invention,
- la figure 3 est une représentation détaillée de l'une des étapes du procédé de décodage de la figure 2,
- la figure 4 est un schéma en blocs d'un décodeur selon l'invention,
- les figures 5 et 6 sont des représentations plus détaillées de certains blocs de la figure 4,
- la figure 7 est un schéma en bloc d'un décodeur pour un code produit à deux dimensions dont chacun des codes est un code de Hamming étendu.

Dans la suite de la description, on utilise un code binaire en bloc étendu. Pour plus de détails sur ce type de code on se reportera par exemple à l'ouvrage de Arnold M. Michelson et Allen H. Levesque intitulé "Error control techniques for digital communications", publié aux éditions Wiley Intersciences en 1985.

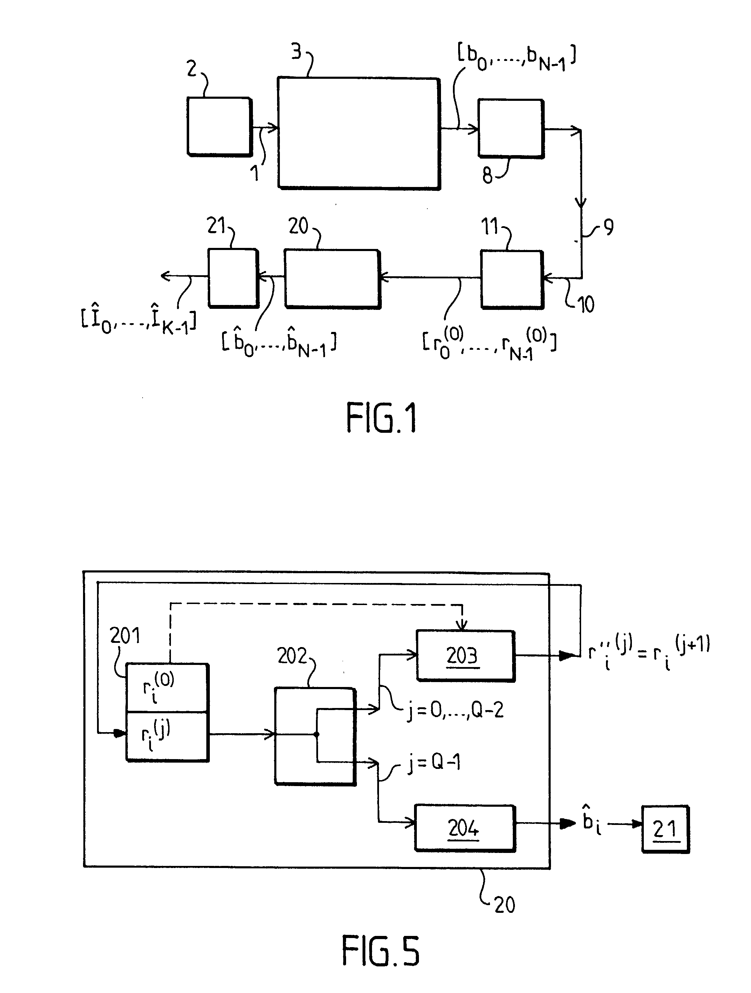

Le code utilisé est un code de longueur N et de dimension K. Ainsi, comme cela est indiqué sur la figure 1, des informations à protéger, issues d'une source 2, sont découpées en mots de K bits $[I_0, ..., I_{K-1}]$ qui sont traités par des moyens de codage 3. Ces moyens de codage génèrent, pour chaque mot d'information, un mot de code de N bits $[b_0, ..., b_{N-1}]$. Le nombre de bits de redondance du code est donc (N-K). Les mots de code délivrés en sortie des moyens de codage 3 sont affectés à des symboles d'une constellation par des moyens de modulation 8. Ces symboles sont transmis à travers un canal 9. Dans l'exemple décrit ici la constellation utilisée est une constellation QPSK de telle sorte que le décodage consiste à prendre une décision entre deux valeurs possibles (+1 et -1) pour chaque symbole reçu sur les voies en quadrature et en phase.

L'invention est applicable à d'autres types de constellation notamment à une constellation BPSK.

En réception, les données reçues 10 sont traitées par des moyens habituel de démodulation 11. Les symboles réels $[r_0^{(0)}, ..., r_{N-1}^{(0)}]$ délivrés en sortie des moyens de démodulation 11 sont fournis à des moyens 20 de décodage itératif qui délivrent une estimation $[\hat{b}_0, ..., \hat{b}_{N-1}]$ du mot de code qui a été transmis.

Ces N bits d'estimation sont alors transmis à des moyens d'extraction 21 qui délivrent une estimation $[\hat{I}_0, ..., \hat{I}_{K-1}]$ du mot d'information transmis.

Soit H=[$h_{ji}$] la matrice de contrôle de parité qui définit le code utilisé. Cette matrice est une matrice de dimension (N-K).N dont les éléments $h_{ji}$ valent 0 ou 1.

Elle permet de définir une première série (1) d'équations de contrôle de parité:

$$(1): Hb^T=[0]$$

où $b^T$ est le vecteur colonne formé par la transposée du mot de code [$b_0$, ..., $b_{N-1}$]. Les équations (1) s'écrivent aussi pour j=0, ..., N-K-1:

$$\sum_{i=0}^{N-1} h_{ji}b_i = 0$$

ou encore:

$$\sum_{i \in S_j} b_i = 0$$

où $\Sigma$ désigne la somme modulo 2 et $S_j$ est l'ensemble des indices compris dans {0, ..., N-1} tels que $h_{ji}$=1. Chacune de ces équations est assimilable à un code de parité simple noté $C_j$ appliqué au mot [$b_0$, ..., $b_{N-1}$].

Lorsque le code utilisé est un code étendu, la parité globale des bits du mot de code est satisfaite (ce qui se traduit par le fait que la dernière ligne de la matrice (j=N-K-1) est une ligne de 1). La relation (2) est donc également vérifiée:

$$(2): b_0 \oplus b_1 \oplus b_2 \oplus ... \oplus b_{N-1}=0$$

(le signe $\oplus$ indique la somme modulo 2)

Dans ce cas, la matrice H définit une seconde série d'équations (3) pour j=0, ..., N-1, qui se déduisent des relations (1) et (2):

$$\sum_{i \in \overline{S}_j} b_i = 0$$

où $\overline{S}_j$ est l'ensemble des indices compris dans {0, ..., N-1} tels que $h_{ji}$=0, Comme pour les relations (1), chacune de ces équations est assimilable à un code de parité simple noté $C'_j$ appliqué au mot [$b_0$,...,$b_{N-1}$].

Conformément à l'invention, le décodage est un décodage itératif. Le principe du décodage itératif (ou décodage turbo) a été exposé dans la conférence "Near Shannon error correcting coding and decoding: turbo codes" de A. Glavieux et al, IEEE ICC-93, pages 1064-1071, en mai 1993, pour le décodage de codes concaténés. Il consiste à se rapprocher d'un décodage optimal en effectuant Q itérations d'un décodage non optimal. Les Q-1$^{ème}$ premières itérations consistent à élaborer une décision douce égale au produit d'une information de fiabilité sur un symbole reçu et de la décision, dite décision dure, prise sur ce symbole, et à réinjecter cette décision douce en entrée des moyens de décodage pour l'itération suivante. La dernière itération délivre une décision dure.

L'invention consiste notamment à appliquer ce principe de décodage à un code binaire en blocs. Pour cela, chaque itération j consiste à décoder le code $C_{(j)mod(m)}$, ou avantageusement les codes $C_{(j)mod(m)}$ et $C'_{(j)mod(m)}$ en parallèle lorsque le code est un code étendu (où m=N-K-1 est l'indice de l'avant dernière ligne de la matrice H). En d'autres termes, la matrice de contrôle de parité est traitée ligne par ligne, plusieurs fois de telle sorte que, pour des symboles reçus $r_i^{(0)}$, chaque itération du décodage itératif correspond au décodage du code $C_{(j)mod(m)}$ ou des codes $C_{(j)mod(m)}$ et $C'_{(j)mod(m)}$ définis par la ligne (j) modulo (m) de la matrice.

Dans la suite de la description, on considère que le code est un code étendu.

La première itération (j=0) est appliquée sur les symboles reçus du canal [$r_0^{(0)}$, ..., $r_{N-1}^{(0)}$]. D'une façon générale, l'itération j est appliquée sur un bloc de grandeurs d'entrée [$r_0^{(j)}$, ..., $r_{N-1}^{(j)}$] et elle produit, après décodage des codes $C_{(j)mod(m)}$ et $C'_{(j)mod(m)}$, un bloc de décisions douces [$r'_0^{(j)}$, ..., $r'_{N-1}^{(j)}$]. Dans un mode de réalisation avantageux de l'invention, un autre bloc [$r''_0^{(j)}$, ..., $r''_{N-1}^{(j)}$] est déduit de ce bloc de décisions douces. Cet autre bloc constitue le bloc des grandeurs d'entrée pour l'itération suivante (j+1) de telle sorte que [$r_0^{(j+1)}$,..., $r_{N-1}^{(j+1)}$] = [$r''_0^{(j)}$, ..., $r''_{N-1}^{(j)}$].

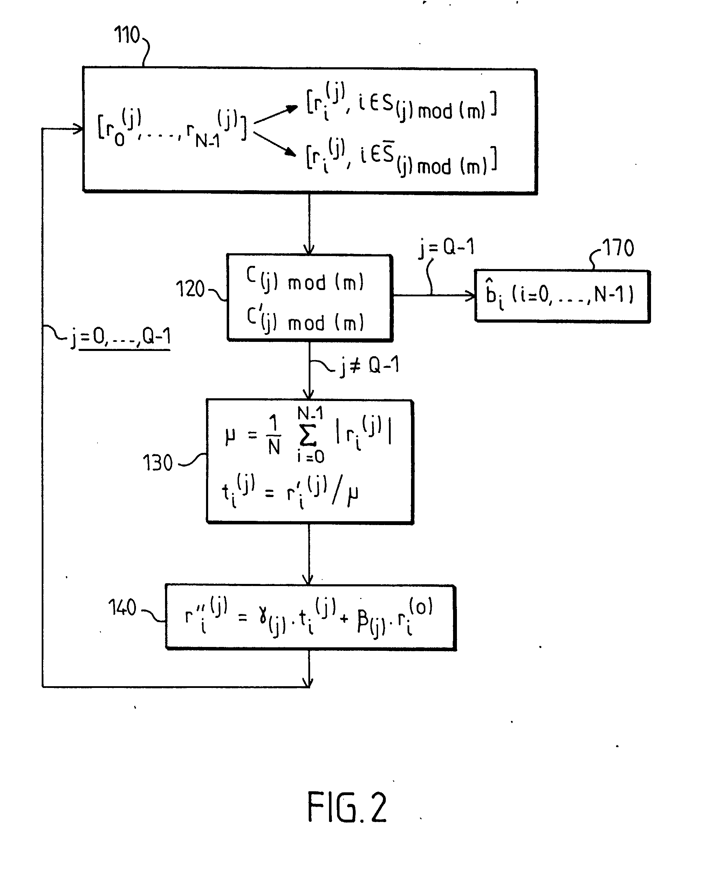

Ce procédé de décodage est résumé sur la figure 2. Il comporte les étapes suivantes, pour chaque itération j:

- étape 110: partage du bloc des grandeurs d'entrée [$r_0^{(j)}$, ...., $r_{N-1}^{(j)}$] en deux groupes, l'un correspondant aux indices compris dans $S_{(j)mod(m)}$, et l'autre correspondant aux indices compris dans $\overline{S}_{(j)mod(m)}$.
- étape 120: décodage de $C_{(j)mod(m)}$ et $C'_{(j)mod(m)}$ appliqué à [$r_i^{(j)}$, $i \in S_{(j)mod(m)}$] et à [$r_i^{(j)}$, $i \in \overline{S}_{(j)mod(m)}$] respectivement.
- étape 130: normalisation des décisions douces $r'_i^{(j)}$: $t_i^{(j)} = r'_i^{(j)} / \mu$ avec

$$\mu = \frac{1}{N}\sum_{i=0}^{N-1} |r_i^{(j)}|$$

Cette normalisation permet de tenir compte du fait que les informations $t_i^{(j)}$ sont théoriquement réparties selon une distribution gaussienne autour des valeurs +1 et -1.

- étape 140: pondération des grandeurs $t_i^{(j)}$ avec les symboles reçus du canal $r_i^{(0)}$: $r''_i^{(j)} = \gamma_{(j)} \cdot t_i^{(j)} + \beta_{(j)} \cdot r_i^{(0)}$ où $\gamma_{(j)}$ et $\beta_{(j)}$ sont les premier et second coefficients de pondération. De façon avantageuse on choisit $\beta_{(j)} = 1 - \gamma_{(j)}$, et $\gamma_{(0)} = 0.5$, $\gamma_{(1)} = 0.7$, $\gamma_{(2)} = 0.9$ et $\gamma_{(j>2)} = 1$. Ainsi, en diminuant le poids des symboles reçus au fur et à mesure des itérations, on tient compte du fait que le risque de divergence diminue avec le nombre d'itérations, tandis que la correction de l'erreur augmente. A l'issue de l'étape 140, le procédé reprend à l'étape 110.

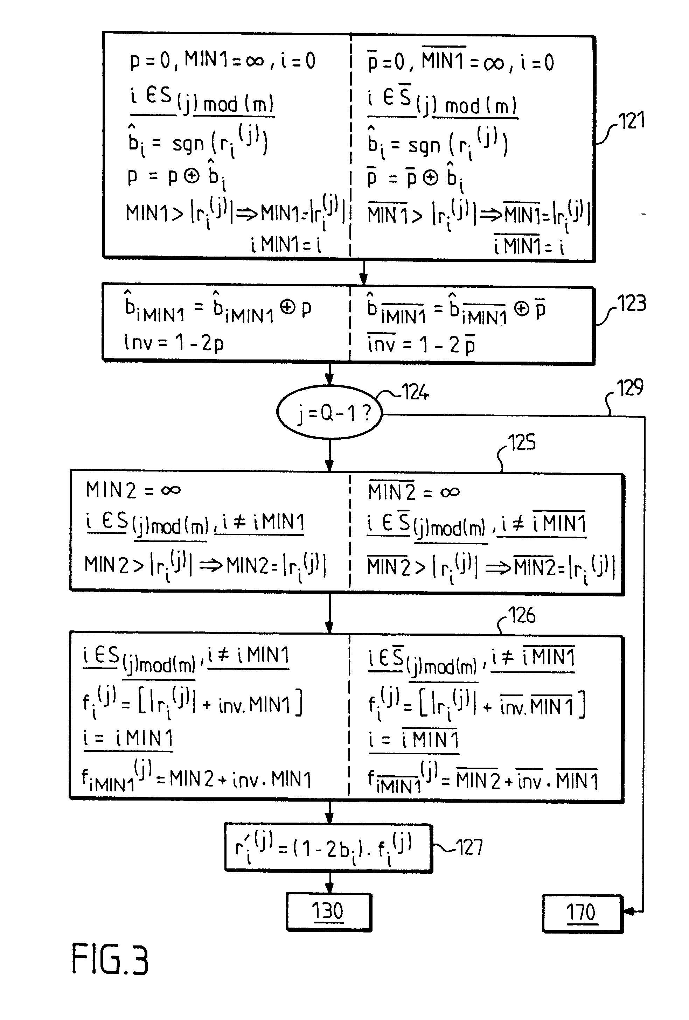

Sur la figure 3 on a détaillé la deuxième étape 120. Cette étape regroupe les étapes suivantes 120 à 126, pour chacun des deux décodages $C_{(j)mod(m)}$ et $C'_{(j)mod(m)}$:

- étape 121: calcul des parités $p$ et $\bar{p}$ des symboles $r_i^{(j)}$ auquel le décodage est appliqué (c'est-à-dire des symboles $[r_i^{(j)}, i \in S_{(j)mod(m)}]$ pour le décodage de $C_{(j)mod(m)}$ et des symboles de $[r_i^{(j)}, i \in \bar{S}_{(j)mod(m)}]$ pour le décodage de $C'_{(j)mod(m)}$), et recherche dans chacun de ces deux ensembles du symbole $r_i^{(j)}$ le moins fiable c'est-à-dire le plus proche de zéro (ces symboles sont appelés premiers minimums et notés MIN1 et $\overline{MIN1}$ respectivement):

  initialisation : $p = 0$, $MIN1 = \infty$, et $\overline{MIN1} = \infty$
  pour $i \in S_{(j)mod(m)}$,
  calcul de $\hat{b}_i = sgn(r_i^{(j)})$, avec $sgn(x) = 0$ si $x > 0$ et 1 sinon
  calcul de $p = p \oplus \hat{b}_i$
  si $MIN1 > |r_i^{(j)}|$ alors $MIN1 = |r_i^{(j)}|$ et $iMIN1 = i$

  et pour $i \in \bar{S}_{(j)mod(m)}$,

  calcul de $\hat{b}_i = sgn(r_i^{(j)})$, avec $sgn(x) = 0$ si $x > 0$ et 1 sinon
  calcul de $\bar{p} = \bar{p} \oplus \hat{b}_i$
  si $\overline{MIN1} > |r_i^{(j)}|$ alors $\overline{MIN1} = |r_i^{(j)}|$ et $\overline{iMIN1} = i$

- étape 123: dans chacun des deux ensembles, correction du symbole le moins fiable, et calcul d'un indicateur de signe noté inv et $\overline{inv}$ respectivement:

$$\hat{b}_{iMIN1} = \hat{b}_{iMIN1} \oplus p \text{ et } inv = 1 - 2p$$
$$\hat{b}_{\overline{iMIN1}} = \hat{b}_{\overline{iMIN1}} \oplus \bar{p} \text{ et } \overline{inv} = 1 - 2\bar{p}$$

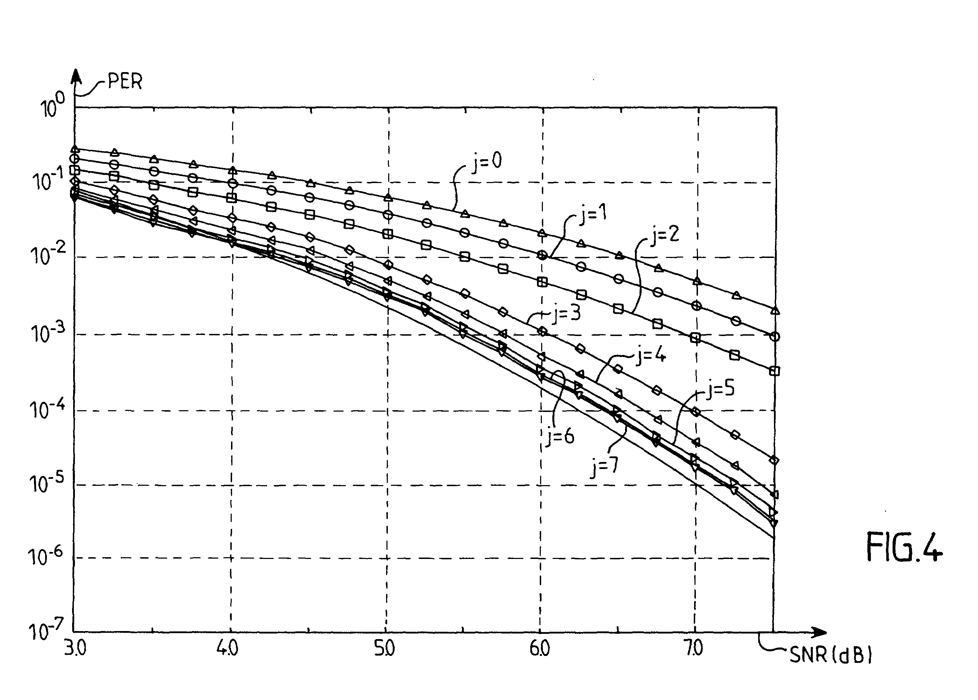

- étape 124: test $j = Q-1$ (où Q est le nombre total d'itérations nécessaires pour se rapprocher du décodage optimal)
  Si $j = Q-1$, le décodage est terminé ce qui est symbolisé sur la figure 4 par une flèche 129 vers une case 170 de fin du procédé. Les décisions dures sont constituées par le bloc $\hat{b}_i$ (i=0, ..., N-1). Si $j \neq Q-1$ l'itération se poursuit avec les étapes suivantes 125, 126 et 127.

- étape 125: recherche du second minimum noté MIN2:

  initialisation: $MIN2 = \infty$, et $\overline{MIN2} = \infty$
  pour $i \in S_{(j)mod(m)}$ et $i \neq iMIN1$, si $MIN2 > |r_i^{(j)}|$, alors $MIN2 = |r_i^{(j)}|$
  et pour $i \in \bar{S}_{(j)mod(m)}$ et $i \neq \overline{iMIN1}$, si $\overline{MIN2} > |r_i^{(j)}|$, alors $\overline{MIN2} = |r_i^{(j)}|$

- étape 126: calcul de la fiabilité $f_i^{(j)}$ et de la décision douce $r'_i^{(j)}$:

  pour $i \in S_{(j)mod(m)}$ et $i \neq iMIN1$, $f_i^{(j)} = [|r_i^{(j)}| + inv. MIN1]$
  pour $i = iMIN1$, $f_{iMIN1}^{(j)} = MIN2 + inv.MIN1$
  pour $i \in \bar{S}_{(j)mod(m)}$ et $i \neq \overline{iMIN1}$, $f_i^{(j)} = [|r_i^{(j)}| + \overline{inv}.\overline{MIN1}]$
  pour $i = \overline{iMIN1}$, $f_{\overline{iMIN1}}^{(j)} = \overline{MIN2} + \overline{inv} . \overline{MIN1}$

- étape 127 : pour tout i variant de 0 à N-1, $r'_i^{(j)} = (1 - 2\hat{b}_i).f_i^{(j)}$

Ce calcul de fiabilité est un calcul classique dont le principe est par exemple rappelé dans l'article "Efficient soft-in-soft-out sub-optimal decoding rule for single parity check codes" publié dans la revue ELECTRONICS LETTERS du 11 Septembre 1997 (Vol.33, N°19).

Dans la pratique, on a constaté qu'un ordre de grandeur de Q=2m itérations permet de converger vers le décodage optimal.

Sur la figure 4, on a présenté les résultats obtenus (taux d'erreur paquet PER en fonction du rapport signal à bruit SNR exprimé en dB au fur et à mesure des itérations pour un code de Hamming étendu H(16, 11) (c'est-à-dire pour N=16, K=11 et m=4).

Les courbes obtenues montrent qu'on converge vers le décodage optimal dès la 7ème itération (sur la figure, le décodage optimal est représenté par un trait continu sans symbole).

On notera que l'invention qui est applicable à tout code binaire en bloc, donne des résultats particulièrement intéressants dans le cas particulier où ce code est un code de Hamming.

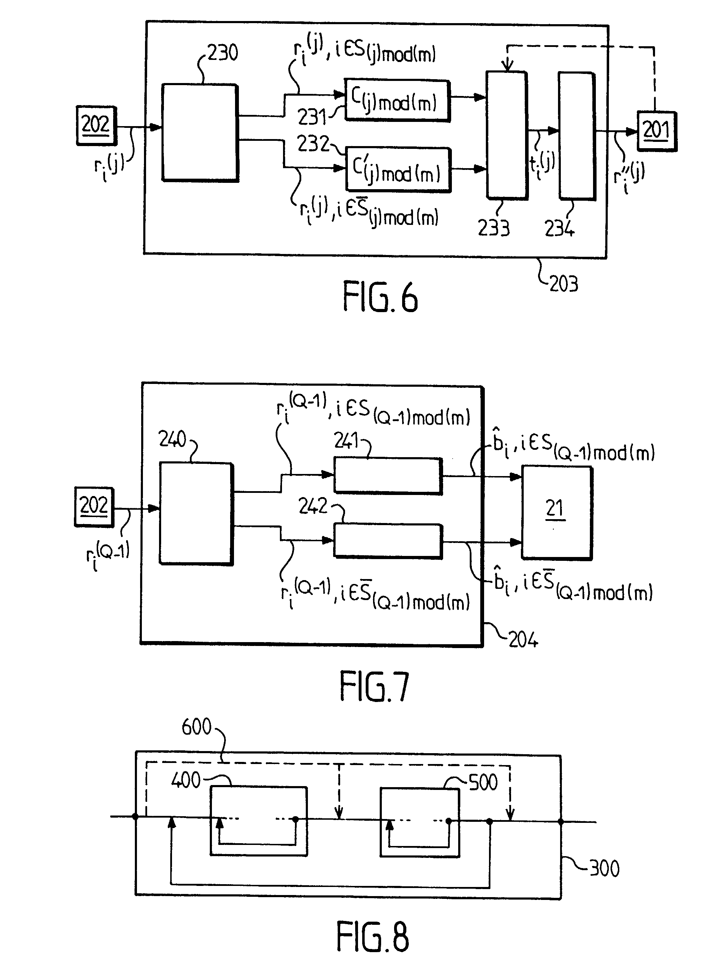

Sur la figure 5, on a représenté sous forme d'un schéma en blocs un exemple de réalisation des moyens 20 de décodage selon l'invention. Ils comportent une mémoire 201 dans laquelle on stocke sous forme d'un premier enregistrement les symboles reçus du canal $[r_0^{(0)}, ..., r_{N-1}^{(0)}]$ et sous forme d'un second enregistrement les sommes pondérées $[r''_0^{(j)}, ..., r''_{N-1}^{(j)}]$ délivrées à chaque itération j. Chaque bloc $[r_0^{(j)}, ..., r_{N-1}^{(j)}]$

lu dans la mémoire 201 est appliqué en entrée d'un routeur 202 qui adresse les grandeurs d'entrée correspondant aux Q-1$^{\text{ème}}$ premières itérations (j=0 à Q-2) à des moyens de décodage 203 qui délivrent les sommes pondérées $[r''_0{}^{(j)}, ..., r''_{N-1}{}^{(j)}]$ stockées dans la mémoire 201, et les grandeurs d'entrée correspondant à la Q$^{\text{ème}}$ itération (j=Q-1) à des moyens de décodage 204 qui délivrent des décisions dures $[\hat{b}_0, ..., \hat{b}_{N-1}]$ qui sont transmises aux moyens d'extraction 21.

Sur la figure 6, on a représenté en détails sous forme d'un schéma en blocs, les moyens de décodage 203. Ils comportent un démultiplexeur 230 qui reçoit, en provenance du routeur 202, les grandeurs d'entrée $[r_0{}^{(j)}, ..., r_{N-1}{}^{(j)}]$, pour l'itération j. Ce démultiplexeur 230 délivrent les grandeurs $[r_i{}^{(j)}, i \in S_{(j)\text{mod}(m)}]$ à des premiers moyens de décodage 231 pour décoder le code $C_{(j)\text{mod}(m)}$, et les grandeurs $[r_i{}^{(j)}, i \in \overline{S}_{(j)\text{mod}(m)}]$ à des seconds moyens de décodage 232 pour décoder le code $C'_{(j)\text{mod}(m)}$. En sortie des premiers moyens de codage 231 on obtient les décisions douces $[r'_i{}^{(j)}, i \in S_{(j)\text{mod}(m)}]$, et en sortie des seconds moyens de décodage 232 on obtient les décisions douces $[r'_i{}^{(j)}, i \in \overline{S}_{(j)\text{mod}(m)}]$. Ces décisions douces sont fournies en entrée de moyens 233 de normalisation. Ces moyens 233 de normalisation délivrent des grandeurs $t_i{}^{(j)}$ qui sont fournies à des moyens 234 de pondération. Les moyens de pondération 234 reçoivent par ailleurs, en provenance de la mémoire 201, les symboles $r_i{}^{(0)}$ qui ont été reçus du canal. Ils délivrent des grandeurs $r''_i{}^{(j)}$ qui constituent les grandeurs d'entrée $r_i{}^{(j+1)}$ pour l'itération suivante, et qui sont stockées dans la mémoire 201.

Sur la figure 7, on a représenté en détails sous forme d'un schéma en blocs, les moyens de décodage 204. De même que les moyens de codage 203, ils comportent un démultiplexeur 240 qui reçoit, en provenance du routeur 202, les grandeurs d'entrée $[r_0{}^{(Q-1)}, ..., r_{N-1}{}^{(Q-1)}]$, pour l'itération Q-1. Ce démultiplexeur 240 délivrent les grandeurs $[r_i{}^{(Q-1)}, i \in S_{(Q-1)\text{mod}(m)}]$ à des premiers moyens de décodage 241 pour décoder le code $C_{(Q-1)\text{mod}(m)}$, et les grandeurs $[r_i{}^{(Q-1)}, i \in \overline{S}_{(Q-1)\text{mod}(m)}]$ à des seconds moyens de décodage 242 pour décoder le code $C'_{(Q-1)\text{mod}(m)}$. En sortie des premiers moyens de codage 241 on obtient les décisions dures $[\hat{b}_i, i \in S_{(Q-1)\text{mod}(m)}]$, et en sortie des seconds moyens de décodage 242 on obtient les décisions dures $[\hat{b}_i, i \in \overline{S}_{(Q-1)\text{mod}(m)}]$. Ces décisions dures sont fournies aux moyens d'extraction 21.

Dans un autre mode de réalisation de l'invention, la dernière itération j=Q-1 délivre un bloc de décision douces (ou de sommes pondérées obtenues à partir de ces décisions douces). Ce mode de réalisation permet d'utiliser la méthode de décodage qui vient d'être décrite pour décoder un code produit pour lequel au moins l'un des codes utilisés est un code binaire en bloc (on appelle code produit un code qui peut être représenté par une matrice à plusieurs dimensions, dont chaque dimension donne un mot de code, les codes utilisés pour chaque dimension pouvant être différents).

Pour décoder un code produit on utilise de façon connue un décodage itératif qui consiste à alterner un décodage de la matrice selon chacune de ses dimensions, plusieurs fois. Pour chacun de ces décodages on doit disposer en entrée de décisions douces, d'où la nécessité de délivrer une décision douce pour la dernière itération en sortie des moyens de décodage selon l'invention.

Sur la figure 8, on a représenté schématiquement un exemple de décodeur 300 pour un code produit à deux dimensions, dont chacun des codes est un code binaire en bloc étendu. Ce décodeur 300 comporte des premiers moyens de décodage 400 pour effectuer un décodage par ligne de la matrice, et des seconds moyens de décodage 500 pour effectuer un décodage par colonne de la matrice. Ces moyens de décodage 400 et 500 sont similaires à ceux qui viennent d'être décrits, mais délivrent des décisions douces à la dernière itération (à l'exception de la dernière itération des moyens de décodage 500, pour la dernière itération du décodeur 300).

Dans un autre mode de réalisation, schématisé par des flèches en pointillés 600 sur la figure 8, les performances sont encore améliorées en pondérant les décisions douces des matrices délivrées en sortie des moyens de décodage 400 et 500 avec les symboles reçus en provenance du canal.

L'invention n'est pas limitée au mode de réalisation qui vient d'être décrit à titre d'exemple. En particulier, les étapes de normalisation 130 et de pondération 140, ou l'une de ces étapes, pourraient être omises ce qui conduirait à une baisse des performances du système.

## Revendications

1. Système de transmission numérique comportant en émission des moyens de codage (3) de données d'entrée (1) à partir d'un code binaire en bloc défini par une matrice de contrôle de parité, et en réception des moyens de décodage (20) pour prendre des décisions sur des données reçues (10), caractérisé en ce que lesdits moyens de décodage sont des moyens de décodage itératif, chaque itération correspondant au décodage, pour des données reçues, du ou des codes définis par une ligne de la matrice.

2. Système de transmission numérique, selon la revendication 1, caractérisé en ce que ledit code binaire en bloc étant un code étendu, chaque ligne de la matrice définit deux codes distincts ($C_{(j)\text{mod}(m)}$ et $C'_{(j)\text{mod}(m)}$), et lesdits moyens de décodage itératif (20) comportent des moyens (231 et 232) de traitement en parallèle de chacun des deux codes.

3. Système de transmission numérique selon l'une des revendications 1 ou 2, caractérisé en ce que lesdits moyens de décodage comportent, pour le traitement de certaines itérations au moins:

- des moyens de calcul, à partir de grandeurs d'entrée ($r_i^{(j)}$), d'informations de fiabilité ($f_i^{(j)}$) relatives à des décisions douces ($r'_i^{(j)}$),
- des moyens de transformation pour calculer des informations transformées ($t_i^{(j)}$) à partir desdites décisions douces de façon à normaliser la valeur moyenne desdites informations de fiabilité,
- des moyens de pondération pour calculer des sommes pondérées ($r''_i^{(j)}$) desdites informations transformées et des données reçues ($r_i^{(0)}$) avec un premier ($\alpha_{(j)}$) et un second ($\beta_{(j)}$) coefficient de pondération respectivement,
- des moyens d'élaboration de grandeurs d'entrée ($r_i^{(j+1)}$) à réinjecter pour l'itération suivante à partir desdites sommes pondérées.

4. Procédé de décodage de données préalablement codées à partir d'un code binaire en bloc défini par une matrice de contrôle de parité, caractérisé en ce que ledit procédé est un procédé de décodage itératif qui comporte à chaque itération une étape (120) de décodage, pour des données reçues, du ou des codes définis par une ligne de la matrice.

5. Procédé de décodage de données selon la revendication 4, caractérisé en ce que ledit code binaire en bloc étant un code étendu, chaque ligne de la matrice définit deux codes distincts ($C_{(j)\mathrm{mod}(m)}$, $C'_{(j)\mathrm{mod}(m)}$), et ladite étape de décodage traite en parallèle chacun des deux codes.

6. Procédé de décodage de données selon l'une des revendications 4 ou 5, caractérisé en ce que ladite étape de décodage comporte, pour le traitement de certaines itérations au moins:

- une étape (126) de calcul, à partir de grandeurs d'entrée, d'informations de fiabilité relatives à des décisions douces,
- une étape (130) de transformation pour calculer des informations transformées à partir desdites décisions douces de façon à normaliser la valeur moyenne desdites informations de fiabilité,
- une étape (140) de pondération pour calculer des sommes pondérées desdites informations transformées et des données reçues avec un premier et un second coefficient de pondération respectivement,
- une étape d'élaboration de grandeurs d'entrée à réinjecter pour l'itération suivante à partir desdites sommes pondérées.

7. Décodeur de données préalablement codées à partir d'un code binaire en bloc défini par une matrice de contrôle de parité, caractérisé en ce qu'il comporte des moyens (20) de décodage itératif, chaque itération correspondant au décodage, pour des données reçues, du ou des codes définis par une ligne de la matrice.

8. Décodeur selon la revendication 7, caractérisé en ce que ledit code binaire en bloc étant un code étendu, chaque ligne de la matrice définit deux codes distincts ($C_{(j)\mathrm{mod}(m)}$ et $C'_{(j)\mathrm{mod}(m)}$), et lesdits moyens de décodage itératif comportent des moyens de traitement en parallèle de chacun des deux codes.

9. Décodeur selon l'une des revendications 7 ou 8, caractérisé en ce que lesdits moyens de décodage comportent, pour le traitement de certaines itérations au moins:

- des moyens de calcul, à partir de grandeurs d'entrée, d'informations de fiabilité relatives à des décisions douces,
- des moyens de transformation pour calculer des informations transformées à partir desdites décisions douces de façon à normaliser la valeur moyenne desdites informations de fiabilité,
- des moyens de pondération pour calculer des sommes pondérées desdites informations transformées et des données reçues avec un premier et un second coefficient de pondération respectivement,
- des moyens d'élaboration de grandeurs d'entrée à réinjecter pour l'itération suivante à partir desdites sommes pondérées.

FIG.1

FIG.5

FIG.2

$$p = 0, \ MIN1 = \infty, \ i = 0$$
$$\underline{i \in S}_{(j) \bmod (m)}$$
$$\hat{b}_i = sgn\left(r_i^{(j)}\right)$$
$$p = p \oplus \hat{b}_i$$
$$MIN1 > |r_i^{(j)}| \Rightarrow MIN1 = |r_i^{(j)}|$$
$$i\,MIN1 = i$$

$$\overline{p} = 0, \ \overline{MIN1} = \infty, \ i = 0$$
$$\underline{i \in \overline{S}}_{(j) \bmod (m)}$$
$$\hat{b}_i = sgn\left(r_i^{(j)}\right)$$
$$\overline{p} = \overline{p} \oplus \hat{b}_i$$
$$\overline{MIN1} > |r_i^{(j)}| \Rightarrow \overline{MIN1} = |r_i^{(j)}|$$
$$\overline{i\,MIN1} = i$$

— 121

$$\hat{b}_{i\,MIN1} = \hat{b}_{i\,MIN1} \oplus p$$
$$inv = 1 - 2p$$

$$\hat{b}_{\overline{i\,MIN1}} = \hat{b}_{\overline{i\,MIN1}} \oplus \overline{p}$$
$$\overline{inv} = 1 - 2\overline{p}$$

— 123

124 — $j = Q - 1\,?$    129

— 125

$$MIN2 = \infty$$
$$\underline{i \in S}_{(j)\bmod(m)}, \ i \neq i\,MIN1$$
$$MIN2 > |r_i^{(j)}| \Rightarrow MIN2 = |r_i^{(j)}|$$

$$\overline{MIN2} = \infty$$
$$\underline{i \in \overline{S}}_{(j)\bmod(m)}, \ i \neq \overline{i\,MIN1}$$
$$\overline{MIN2} > |r_i^{(j)}| \Rightarrow \overline{MIN2} = |r_i^{(j)}|$$

— 126

$$\underline{i \in S}_{(j)\bmod(m)}, \ i \neq i\,MIN1$$
$$f_i^{(j)} = \left[\,|r_i^{(j)}| + inv.\,MIN1\,\right]$$
$$i = i\,MIN1$$
$$f_{i\,MIN1}^{(j)} = MIN2 + inv.\,MIN1$$

$$\underline{i \in \overline{S}}_{(j)\bmod(m)}, \ i \neq \overline{i\,MIN1}$$
$$f_i^{(j)} = \left[\,|r_i^{(j)}| + \overline{inv}.\,\overline{MIN1}\,\right]$$
$$i = \overline{i\,MIN1}$$
$$f_{\overline{i\,MIN1}}^{(j)} = \overline{MIN2} + \overline{inv}.\,\overline{MIN1}$$

$$r_i^{'(j)} = (1 - 2b_i).\,f_i^{(j)}$$ — 127

<u>130</u>

<u>170</u>

FIG.3

9

FIG.4

FIG.6

FIG.7

FIG.8

**Office européen des brevets**

## RAPPORT DE RECHERCHE EUROPEENNE

Numéro de la demande

EP 99 20 0361

### DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| X | EP 0 654 910 A (FRANCE TELECOM) 24 mai 1995 * page 6, ligne 19 - page 8, ligne 25; figure 3 * | 1,3,4,6, 7,9 | H03M13/00 |
| X | PYNDIAH ET AL.: "Near optimum decoding of product codes" PROCEEDINGS OF THE GLOBAL TELECOMMUNICATIONS CONFERENCE, vol. 1, 28 novembre 1994 - 2 décembre 1994, pages 339-343, XP000488569 San Francisco, US * alinéa II - alinéa III * | 1,3,4,6, 7,9 | |
| A | LODGE ET AL.: "Separable MAP filters for the decoding of product and concatenated codes" PROCEEDINGS OF THE INTERNATIONAL CONFERENCE ON COMMUNICATIONS (ICC), vol. 3, 23 - 26 mai 1993, pages 1740-1745, XP000448423 Geneva, CH * alinéa 3 * | 2,5,8 | DOMAINES TECHNIQUES RECHERCHES (Int.Cl.6) H03M |

Le présent rapport a été établi pour toutes les revendications

| Lieu de la recherche | Date d'achèvement de la recherche | Examinateur |
|---|---|---|
| LA HAYE | 10 juin 1999 | Augarde, E |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**   EP 99 20 0361

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

10-06-1999

| Document brevet cité au rapport de recherche | Date de publication | Membre(s) de la famille de brevet(s) | | Date de publication |
|---|---|---|---|---|
| EP 654910 A | 24-05-1995 | FR | 2712760 A | 24-05-1995 |
| | | DE | 69412570 D | 24-09-1998 |
| | | DE | 69412570 T | 22-04-1999 |
| | | JP | 7202722 A | 04-08-1995 |
| | | US | 5563897 A | 08-10-1996 |

EPO FORM P0460

Pour tout renseignement concernant cette annexe : voir Journal Officiel de l'Office européen des brevets, No.12/82